# EUROPÄISCHE PATENTANMELDUNG

(11) **EP 2 674 983 A1**
(43) Veröffentlichungstag der Anmeldung: **18.12.2013**
(21) Anmeldenummer: 13002592.7
(22) Anmeldetag: 16.05.2013
(51) Int. Cl.: H01L 31/02, H01L 31/048

(54) **Anschlußverbinder für Photovoltaikmodule**

(30) Priorität: 11.06.2012 DE 102012011346
(71) Anmelder: Carl Freudenberg KG, 69469 Weinheim (DE)
(72) Erfinder: Runge, Olaf, 10318 Berlin (DE); Bayerlein, Alexander, 10245 Berlin (DE)

(57) **Zusammenfassung**

Ein Anschlußverbinder für Photovoltaikmodule, umfassend eine Modulfront (1), eine Modulrückfront (2, 14) und eine Solarzelle (3), welche zwischen der Modulfront (1) und der Modulrückfront (2, 14) sandwichartig aufgenommen ist, wobei die Solarzelle (3) mindestens eine Kontaktleitung (4) aufweist, ist im Hinblick auf die Aufgabe, einen Anschlußverbinder für Photovoltaikmodule derart auszugestalten und weiterzubilden, dass dieser nach einfacher und kostengünstiger Fertigung eine dichte Aufnahme einer Solarzelle und eine problemlose elektrische Anbindung der Solarzelle ermöglicht, dadurch gekennzeichnet, dass die Kontaktleitung (4) seitlich aus dem Anschlußverbinder herausgeführt und dabei zwischen der Modulfront (1) und der Modulrückfront (2, 14) sandwichartig aufgenommen ist.

## Beschreibung

### Technisches Gebiet

Die Erfindung betrifft einen Anschlußverbinder für Photovoltaikmodule gemäß dem Oberbegriff des Patentanspruchs 1.

### Stand der Technik

Aus dem Stand der Technik ist es bekannt, Anschlußverbinder oder Solarmodule aus einer gläsernen Modulrückfront und einer gläsernen Modulfront zu fertigen, welche zwischen sich eine Solarzelle sandwichartig aufnehmen.

Neben Glas-Glas-Modulen kommen auch Glas-Folien-Modulen mit oder ohne Rahmen zum Einsatz.

Ein Solarmodul bzw. eine Solarzelle weist mindestens eine Kontaktleitung auf, welche mit einem Anschlusskabel und/ oder einer Anschlussdose elektrisch leitend verbunden ist.

Die Kontaktleitung wird durch ein Loch in der Modulrückfront geführt, um mit dem Anschlusskabel verbunden zu werden. Die Bohrung oder Öffnung kann mit einer Vergussmasse verschlossen werden.

Beim Einbringen von Öffnungen oder Löchern in gläserne Modulrückfronten oder Folien können diese sehr leicht geschädigt werden, insbesondere zerbrechen oder zersplittern. Die Folge ist eine hohe Auschussrate bei der Fertigung von Anschtußverbindern bzw. Solarmodulen.

Überdies können Haltbarkeitsprobleme auftreten, da ein Anschlußverbinder eine Lebensdauer von mindestens 20 Jahren zeigen muss. Dies erfordert eine hohe Witterungsbeständigkeit. Um das Eindringen von Feuchtigkeit zu verhindern, werden Hohlräume zum Teil ausgegossen oder ausgespritzt.

Eine häufige Fehlerquelle bei den bekannten Anschlußverbindern liegt in der Durchdringung der Modulrückfront, welche aus Glas oder Folie bestehen kann, um eine Kontaktierung des Anschlußverbinders herzustellen.

### Darstellung der Erfindung

Der Erfindung liegt daher die Aufgabe zugrunde, einen Anschlußverbinder für Photovoltaikmodule derart auszugestalten und weiterzubilden, dass dieser nach einfacher und kostengünstiger Fertigung eine dichte Aufnahme einer Solarzelle und eine problemlose elektrische Anbindung der Solarzelle ermöglicht.

Die vorliegende Erfindung löst die zuvor genannte Aufgabe durch einen Anschlußverbinder für Photovoltaikmodule mit den Merkmalen des Patentanspruchs 1.

Erfindungsgemäß ist erkannt worden, dass eine Glasscheibe oder Folie, insbesondere eine Modulrückfront eines Anschlußverbinders oder Solarmoduls, nicht mehr gebohrt und geschliffen bzw. penetriert werden muss, um eine elektrische Kontaktierung einer Solarzelle zu ermöglichen. Eine Abdichtung einer Bohrung kann entfallen. So können erhebliche Kosten eingespart werden.

Das Kontaktsystem wird seitlich aus dem Verbund aus Modulfront, Solarzelle und Modulrückfront herausgeführt. Hierdurch kann auf Bohren und Säumen von Scheiben und Folien verzichtet werden. Die Adaption unterschiedlicher Kabelsätze und Anschlussdosen kann überdies von der Herstellung des Feuchte-Schutzes separiert werden.

Die Erfindung betrifft insoweit eine Möglichkeit zur elektrischen Kontaktierung von Photovoltaikmodulen.

Folglich ist die eingangsgenannte Aufgabe gelöst.

Die Kontaktleitung könnte als Flex-Leiter ausgebildet sein, der eine Dichtung aufweist. Ein Flex-Leiter ist besonders flach ausgebildet und läßt sich problemlos in einem engen Spalt zwischen Modulfront und Modulrückfront aufnehmen. Eine an ihm angeordnete Dichtung verhindert, dass Flüssigkeit zwischen die Modulfront und die Modulrückfront eintritt.

Die Kontaktleitung könnte mit einem Anschlusskabel an einer Verbindung verbunden sein, wobei die Verbindung eine Vergussmasse aufweist oder in einer Vergussmasse vergossen ist. Die Vergussmasse stellt eine elektrische Isolierung und einen feuchtigkeitsdichten Schutz gegen Witterungseinflüsse sicher. Innerhalb der Vergussmasse können auch weitere elektrische Komponenten, insbesondere Bypassdioden, eingebracht werden. Das Anschlusskabel kann mit einem Endsteckergehäuse verbunden werden.

Die Solarzelle könnte als Schicht oder Dünnschicht ausgebildet sein. Konkret ist denkbar, dass die Schicht aus einem Verbund aus Strings oder Drähten und Fügewerkstoffen besteht, wobei die Strings oder Drähte zwischen zwei Lagen aus Fügewerkstoffen aufgenommen sind. Hierdurch kann die Solarzelle besonders einfach gefertigt werden.

Eine Anordnung, welche eine Modulfront und eine Solarzelle umfasst, welche mit der Modulfront verbunden ist, wobei die Solarzelle mindestens eine als Flex-Leiter ausgebildete Kontaktleitung aufweist, könnte in einem Anschlußverbinder der hier beschriebenen Art verwendet werden. Hierdurch wird die Montage eines Anschlußverbinders vereinfacht und werden Kosten gespart. Es muss lediglich noch eine Modulrückfront aufgesetzt werden und diese durch einen Klebstoff mit der Modulfront verbunden werden. Ein geeigneter Klebstoff dichtet den Innenraum zwischen Modulfront und Modulrückfront, in welchem die Solarzelle aufgenommen ist, flüssigkeitsdicht ab. Durch den Klebstoff hindurch ragt der Flex-Leiter mit einer Dichtung aus dem Anschlußverbinder heraus.

Es ist denkbar, die Anordnung werksseitig mit einem Anschlusskabel auszurüsten, welches über eine Verbindung mit Vergussmasse an die Kontaktleitung angebunden ist.

Es ist weiter denkbar, die Anordnung werksseitig mit einem Anschlusskabel auszurüsten, welches über eine Verbindung mit Vergussmasse an die Kontaktleitung angebunden ist, wobei das Anschlusskabel mit einem Endsteckergehäuse verbunden ist.

Der Anschlußverbinder kann sandwichartig und durch thermische Prozesse, insbesondere durch Lamination, gefertigt sein. Dabei können mehrere Lagen aus Glas und/ oder Folie miteinander verbunden sein. Vor diesem Hintergrund ist denkbar, kristalline Anschlußverbinder zu verwenden.

Die hier beschriebene Erfindung ist in der Solarindustrie bei der Kontaktierung von Zellen oder Schichten mit einem oder mehreren Kabelsätzen einsetzbar.

### Kurzbeschreibung der Zeichnung

In der Zeichnung zeigen
- Fig. 1: eine schematische Ansicht der Fertigungsschritte eines Anschlußverbinders des Stands der Technik sowie den Anschlußverbinder,
- Fig. 2: eine schematische Ansicht der Fertigungsschritte eines erfindungsgemäßen Anschlußverbinders sowie den Anschlußverbinder und
- Fig. 3: eine schematische Ansicht der Fertigungsschritte eines weiteren erfindungsgemäßen Anschlußverbinders sowie den Anschlußverbinder.

### Ausführung der Erfindung

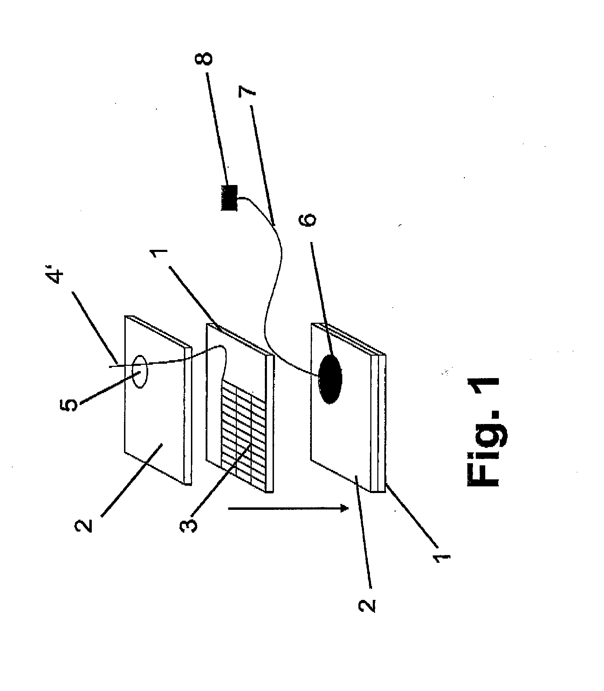

Fig. 1 zeigt einen Anschlußverbinder des Stands der Technik, umfassend eine Modulfront 1, eine Modulrückfront 2 und eine Solarzelle 3, welche zwischen der Modulfront 1 und der Modulrückfront 2 sandwichartig aufgenommen ist, wobei die Solarzelle 3 mindestens eine Kontaktleitung 4' aufweist.

Die Kontaktleitung 4' ragt durch ein Loch 5 durch die Modulrückfront 2. Das Loch 5 ist durch eine Vergussmasse 6 verschlossen und durch eine AnschlussDose abgedeckt. Die Kontaktleitung 4' ist mit einem Anschlusskabel 7 mit einem Endsteckergehäuse 8 verbunden.

Die obere Ansicht der Fig. 1 zeigt den Anschlußverbinder vor bzw. während des Zusammenbaus, die untere Ansicht zeigt den fertigen Anschlußverbinder.

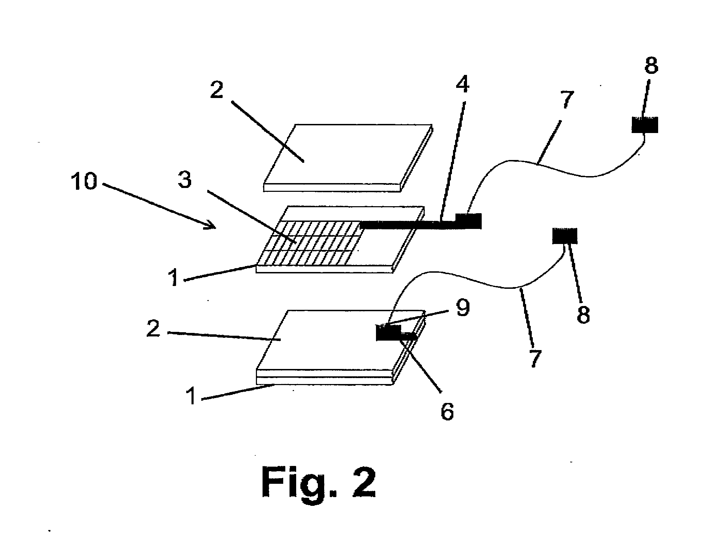

Fig. 2 zeigt einen erfindungsgemäßen Anschlußverbinder, umfassend eine Modulfront 1, eine Modulrückfront 2 und eine Solarzelle 3, welche zwischen der Modulfront 1 und der Modulrückfront 2 sandwichartig aufgenommen ist, wobei die Solarzelle 3 mindestens eine Kontaktleitung 4 aufweist. Die Kontaktleitung 4 ist seitlich aus dem Anschlußverbinder herausgeführt und dabei zwischen der Modulfront 1 und der Modulrückfront 2 sandwichartig aufgenommen.

Es können auch mehrere Kontaktleitungen 4 vorgesehen sein.

Die Kontaktleitung 4 ist als Flex-Leiter ausgebildet, der eine Dichtung aufweist. Die Kontaktleitung 4 ist mit einem Anschlusskabel 7 an einer Verbindung 9 verbunden, wobei die Verbindung 9 in einer Vergussmasse 6 vergossen ist.

Das Anschlusskabel 7 mit umgossener Verbindung 9 wird auf der gläsernen Modulrückfront 2 oder an einem Rahmen befestigt.

Die obere Ansicht der Fig. 2 zeigt den Anschlußverbinder vor bzw. während des Zusammenbaus, die untere Ansicht zeigt den fertigen Anschlußverbinder.

In der oberen Ansicht ist eine vorgefertigt anlieferbare Anordnung 10 zur Verwendung in einem Anschlußverbinder gezeigt, welche eine Modulfront 1 und eine Solarzelle 3 umfasst, welche mit der Modulfront 1 verbunden ist, wobei die Solarzelle 3 eine als Flex-Leiter ausgebildete Kontaktleitung 4 aufweist, die mit einem Anschlusskabel 7 mit einem Endsteckergehäuse 8 verbunden ist.

Die Modulfront 1 und die Modulrückfront 2 sind als gläserne Scheiben ausgebildet. Auf das Bohren und Säumen der Scheiben wird verzichtet. Insbesondere kann auf das Abdichten einer Bohrung in der Modulrückfront 2 verzichtet werden.

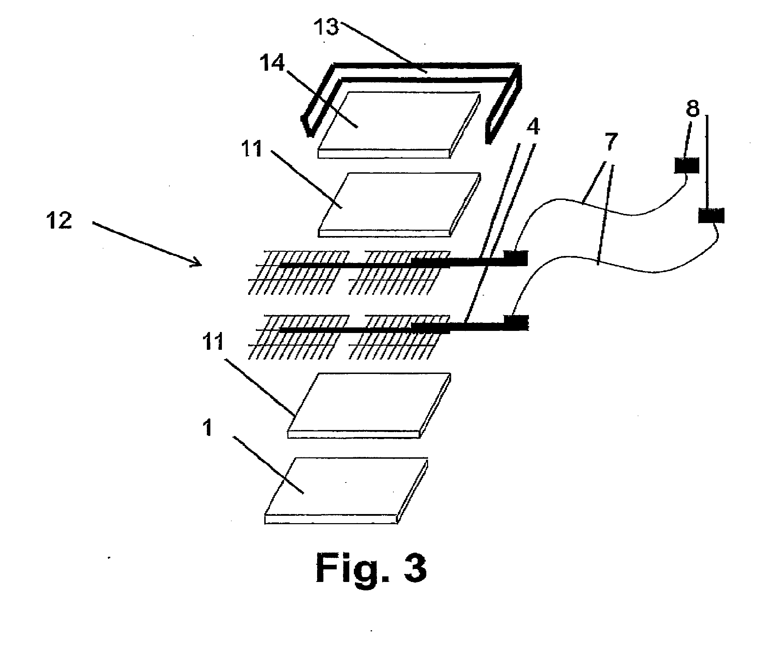

Fig. 3 zeigt einen weiteren Anschlußverbinder, umfassend eine Modulfront 1, eine Modulrückfront 14 und eine Solarzelle, welche zwischen der Modulfront 1 und der Modulrückfront 14 sandwichartig aufgenommen ist, wobei die Solarzelle zwei Kontaktleitungen 4 aufweist. Die Kontaktleitungen 4 sind seitlich aus dem Anschlußverbinder herausgeführt und dabei zwischen der Modulfront 1 und der Modulrückfront 14 sandwichartig aufgenommen.

Die Solarzelle ist als Schicht 11, 12 ausgebildet. Die Schicht 11, 12 besteht aus einem Verbund von kristallinen Einzelzellen, die durch Kontaktleitungen aus Strings oder Drähten 12 elektrisch verbunden sind, und Fügewerkstoffen 11, wobei die Strings oder Drähte 12 zwischen zwei Lagen aus Fügewerkstoffen 11 aufgenommen sind. Die Fügewerkstoffe 11 umfassen den Kunststoff EVA oder PVB. Die Modulrückfront 14 ist aus dem Kunststoff "Tedlar" (eingetragene Marke) gefertigt. Der Anschlußverbinder weist einen Rahmen 13 auf. Durch den Rahmen 13 kann der Anschlußverbinder besser aufgestellt werden und ist somit statisch stabilisiert. Der Rahmen 13 ist U-förmig und kann umlaufend ausgestaltet sein.

## Patentansprüche

1. Anschlußverbinder für Photovoltaikmodule, umfassend eine Modulfront (1), eine Modulrückfront (2, 14) und eine Solarzelle (3), welche zwischen der Modulfront (1) und der Modulrückfront (2, 14) sandwichartig aufgenommen ist, wobei die Solarzelle (3) mindestens eine Kontaktleitung (4) aufweist,
**dadurch gekennzeichnet, dass** die Kontaktleitung (4) seitlich aus dem Anschlußverbinder herausgeführt und dabei zwischen der Modulfront (1) und der Modulrückfront (2, 14) sandwichartig aufgenommen ist.

2. Anschlußverbinder für Photovoltaikmodule nach Anspruch 1, **dadurch gekennzeichnet, dass** die Kontaktleitung (4) als Flex-Leiter ausgebildet ist, der eine Dichtung aufweist.

3. Anschlußverbinder für Photovoltaikmodule nach Anspruch 1 oder 2,
**dadurch gekennzeichnet, dass** die Kontaktleitung (4) mit einem Anschlusskabel (7) an einer Verbindung (9) verbunden ist, wobei die Verbindung (9) eine Vergussmasse (6) aufweist.

4. Anschlußverbinder für Photovoltaikmodule nach einem der Ansprüche 1 bis 3, **dadurch gekennzeichnet, dass** die Solarzelle (3) als Dünnschicht oder Schicht (11, 12) ausgebildet ist.

5. Anordnung (10) zur Verwendung in einem Anschlußverbinder für Photovoltaikmodule nach einem der voranstehenden Ansprüche, umfassend eine Modulfront (1) und eine Solarzelle (3), welche mit der Modulfront (1) verbunden ist, wobei die Solarzelle (3) mindestens eine als Flex-Leiter ausgebildete Kontaktleitung (4) aufweist.
